# EUROPEAN PATENT SPECIFICATION

(11) **EP 0 613 050 B1**
(45) Date of publication and mention of the grant of the patent: **26.03.1997**
(21) Application number: 94480003.6
(22) Date of filing: 14.01.1994
(51) Int. Cl.: G03F 7/038, G03F 7/004

(54) **Universal negative tone photoresist**
Universaler negativ arbeitender Photoresist
Photoréserve universel de type négatif

(30) Priority: 26.02.1993 US 23401
(43) Date of publication of application: 31.08.1994
(73) Proprietor: International Business Machines Corporation, Armonk, N.Y. 10504 (US)
(72) Inventor: Bunsvold, William R., Poughkeepie, N.Y. 12603 (US); Conley, Willard E., Cornwall, N.Y. 12518 (US); Gelorme, Jeffrey D., Plainville, CT 06062 (US); Wood, Robert L., Poughkeepsie, N.Y. 12603 (US); Linehan, Leo L., Walden, N.Y. 12586 (US); Sooriyakumaran, Ratnam, Fishkill, N.Y. 12524 (US); Tai, Tsong-Lin, Stormville, N.Y. 12582 (US)
(74) Representative: Klein, Daniel Jacques Henri

(56) References cited:
- EP-A- 0 441 524
- EP-A- 0 487 794
- EP-A- 0 537 524
- EP-A- 0 543 761

## Description

The present invention provides improved chemically amplified negative tone microlithographic resist compositions and methods for the use thereof. The compositions comprise, in admixture, a crosslinking agent, a polymeric binder, and a compound that generates acid upon exposure of the resist composition to imaging radiation. The invention is particularly related to compositions having a crosslinking agent which does not plasticize the polymeric binder or alternatively does not reduce the glass transition temperature thereof. This minimizes the diffusion of the acid component from exposed regions of the resist to unexposed regions. Such compositions are especially useful in the fabrication of integrated circuit devices by microlithographic techniques.

In the fabrication of integrated circuits, the exposure of a photoresist to radiation is an integral process step. The production of high density circuits having sub micron dimensions requires that such exposure be accomplished within close processing tolerances. For example, it is important to control the linewidth of the imaged and developed photoresist so that any deviation from the nominal design linewidth is small, typically less than ± 10%.

The use of acid sensitive resist compositions is well known in the art. Such resist compositions are especially useful in conjunction with deep UV (180-300 nm) and X-ray exposure tools, in light of their high photospeed requirements. Although positive working resists are preferred for printing contact holes, negative working resists are gaining in popularity because of their usefulness in phase shift lithographic methods. Negative working resists provide higher yields in some lithographic applications and tend to reduce or eliminate the bias observed when printing isolated lines and line and space pairs with the same mask.

Most negative working compositions depend upon a crosslinking agent to react with a polymeric binder to form a base-insoluble film comprised of a higher molecular weight polymer. An exception is a resist disclosed in US-A 4 491 628 which may be processed to form negative tone relief images by means of a polarity change in the polymer binder which renders exposed regions insoluble in organic developer while the unexposed regions dissolve and are removed. Organic developers are generally less desirable and pose a safety hazard because of flammability or toxicity issues. Aqueous developers are preferred in manufacturing. Thus, aqueous developable resist systems are preferred.

US-A 4 148 655 describes an aqueous developable negative working composition comprising polyhydroxystyrene and an azide crosslinking compound. This material has a high optical density when exposed in the deep UV region that leads to concave shaped resist profiles which are unsatisfactory for printing sub-micron features. In certain applications, the sensitivity of this composition is too low to meet manufacturing throughput requirements as the resist is not chemically amplified.

US-A 4 371 605 discloses a chemically amplified negative working composition comprising an epoxy resin and an acid generator which is a N-hydroxyamide or an N-hydroxyimide sulfonate. The patent discloses crosslinking agents which include melamine resins and epoxide monomers and prepolymers. The resinous crosslinking agents disclosed in the patent act to plasticize the binder and thus lower the glass transition temperature (Tg) of the resist composition. The preferred crosslinking agent of the reference is an epoxy resin obtained from the reaction between bisphenol-A and epichlorohydrin which itself has a low Tg, and which lowers the Tg of the resist composition. Accordingly, the phenomenon of acid migration is more pronounced than with the compositions of the present invention.

US-A 5 034 304 describes negative working compositions including novolaks and polyhydroxystyrene binder resins, photosensitive acid generators which are halogenated organic compounds, and aminoplast resins which crosslink in the presence of an acid. Suitable aminoplasts of the reference include urea-formaldehyde, melamine-formaldehyde, benzoquanamine-formaldehyde, and glycoluril-formaldehyde resins. However, the resinous crosslinking agents disclosed in the patent act to plasticize the binder and thus lower the glass transition temperature (Tg) of the resist composition. The preferred crosslinking agent of the reference is a melamine-formaldehyde aminoplast resin comprising hexamethoxymethylmelamine (HMMM) which is commercially available from American Cyanamid Company under the trade name Cymel 303. HMMM is a waxy solid having a low melting point, which lowers the Tg of the resist composition. Cymel 303 is a liquid at room temperature, thus it lowers the Tg of the resist composition. Accordingly, the phenomenon of acid migration is more pronounced than with the compositions of the present invention.

Japanese Patent Application Kokai No. 04-107,560 (1992) discloses a three component negative working resist that is chemically amplified and can be developed with aqueous base. The acid generator is selected from a group of halogenated aromatic compounds. Crosslinking agents include N,N,N',N'-tetramethoxymethyl urea and hexamethoxymethylmelamine (HMMM) while the polymer binder resin is poly(vinylphenol). The crosslinking agents are liquids or waxy low melting solids which lower the Tg of the resist composition. Accordingly, the phenomenon of acid migration is more pronounced than with the compositions of the present invention.

Canadian Patent Application No. 2,060,228 discloses a negative working photoresist comprising a base-soluble phenolic resin containing a phenyl dihydroindene unit that can serve as the polymer binder by itself or in conjunction with novolaks and polyhydroxystyrenes known in the art. The crosslinking compounds disclosed include numerous melamine based and other crosslinking agents, including HMMM. Useful acid generators are substituted triazines, aryl sulfonates, 2-(phenylsulfonyl)acetophenones, and oxime sulfonates. Many of the crosslinking agents are liquids or waxy low melting solids which lower the Tg of the resist composition. Accordingly, the phenomenon of acid migration is more pronounced than with the compositions of the present invention.

Japanese Patent Application Kokai No. 01-293339 (1989) discloses a three component negative working resist that is chemically amplified and can be developed with aqueous base. The resist comprises an acid generator, crosslinking compounds having a -NCH2OR2 group where R2 is hydrogen or C1 to C5 alkyl, and poly(p-hydroxystyrene). The preferred crosslinking agent is Cymel 303. The disclosed crosslinking agents are liquids or waxy low melting solids which lower the Tg of the resist composition. Accordingly, the phenomenon of acid migration is more pronounced than with the compositions of the present invention.

According to the invention, improved chemically amplified negative tone microlithographic resist compositions and methods for the use thereof are provided. The compositions comprise, in admixture, a crosslinking agent, a polymeric binder, and a compound that generates acid upon exposure of the resist composition to imaging radiation. The compositions have a crosslinking agent which does not plasticize the polymeric binder or alternatively does not reduce the glass transition temperature of the polymeric binder. This minimizes the diffusion of the acid component from exposed regions of the resist to unexposed regions.

The present invention provides novel compositions which are improved chemically amplified negative tone microlithographic resists. The compositions comprise, in admixture, a crosslinking agent, a polymeric binder, and a compound that generates acid upon exposure of the resist composition to imaging radiation. The compositions are useful in conjunction with lithographic exposure systems using any of electron beam, ion beam, ultraviolet, or x-ray radiation. The compositions are particularly suitable for patternwise exposure with deep UV radiation. Deep UV is considered to be ultraviolet light having a wavelength in the range from about 180 nm to about 300 nm.

The compositions of the invention are said to be chemically amplified. By this is meant that one photon or energetic particle is absorbed by the acid generator which produces one acid molecule that subsequently can cause up to about a thousand chemical events, or crosslinking reactions, to take place. The acidic moiety acts as a catalyst, because the acid is regenerated after each of many individual reactions. The generation of acid from the radiation sensitive acid generator does not require heat, however, most chemically amplified resists require a post-exposure bake (PEB) of one to two minutes in length to complete the reaction between the acid moiety and the crosslinkable components. During this time, acid diffusion in the film can cause an undesirable effect if acid moieties migrate into unexposed regions. In exposing and developing a chemically amplified acid catalyzed negative resist film, where the ideal aerial image would result in a relief image linewidth of a, and where the acid diffusion path length is z, acid diffusion into unexposed regions will produce a line which is 2z larger than the ideal line size of a, that is, a line having a width of a + 2z. In order to control image size, a resist composition is selected wherein diffusion into unexposed areas is minimized.

The present invention is directed to compositions in which acid diffusion through the polymer matrix is restricted by modifying the matrix environment around the acid generator. The alternative means for reducing diffusion of the acidic moiety by using a weaker acid which catalyzes a much lower number of chemical events before it is neutralized is less desirable. This is because a resist comprising an acid generator which produces a weaker acid requires a higher exposure dose and thus exhibits lower photospeed.

In polymer films, the glass transition temperature (Tg) is one measure of the softness or plasticity of the film. Typical Tg values for polymeric binders which are known in the art are about 110°C for novolaks and about 160 °C for polyhydroxystyrenes. Resist components other than the host polymeric binder which have a melting point below the Tg of the host polymer will lower the Tg of the resist film. Similarly, resinous resist components which are blended with the host polymer and which have a Tg below the Tg of the host polymer will lower the Tg of the resist film. Films that are subjected to process temperatures below their Tg are less susceptible to acid migration and will retain their form, whereas negative tone resist films which are processed at temperatures above their Tg after exposure are adversely affected. Furthermore, movement or diffusion of individual molecules of resist components within the film is minimal when the film is subjected to temperatures which do not exceed the Tg of the resist mixture. Conversely, where the film is processed at a temperature exceeding the Tg, diffusion is exacerbated. Thus, resist compositions in which the Tg which has not been lowered by the inclusion of a component with a plasticizing effect are most advantageous.

In the prior art, preferred crosslinkers are liquids, semi-fluid resins, or waxy components having low melting points or Tg(s) which plasticize the polymer film and exacerbate acid diffusion by providing a less restricted path for the photogenerated acid molecules. With known compositions, our studies have shown a dependence of image size on PEB in the range of about 30 to 40 nm or more per degree C. In a manufacturing process, the equipment used for the PEB can fluctuate by ± 1°C or more which can cause a variation of at least ± 0.04 µm in linewidth. This variation is unacceptable when printing linewidths of 0.50 µm or less that have image tolerances of ± 0.05 µm or less. The linewidth tolerance of about ± 10% includes the contributions of errors from many process steps so that a typical lithographic tolerance of ± 0.025 µm (± 25 nm) is required.

The compositions of the invention are particularly useful for microlithography in that image size is not particularly sensitive to changes in post-exposure bake temperature. A change of less than about ± 10 nm in feature size per change in temperature in degrees C of the PEB is observed in printing negative tone images. In addition, isolated features and alternating line and space patterns of the same dimension can be printed simultaneously with each type of feature exactly replicating the dimension on the mask without any bias. This is especially useful in state-of-the-art semiconductor manufacturing where printing sub-micron images necessitates a tight linewidth tolerance with respect to the target dimension. In a manufacturing process, the linewidth tolerance is usually about ± 10% of the nominal dimension.

The polymeric binders of the invention are polymers which comprise a hydroxyaromatic group. The polymeric binders are further characterized as capable of undergoing crosslinking with a crosslinking agent comprising a carbonium ion by either an electrophilic aromatic substitution reaction or by an O-alkylation reaction as described by Thackeray, et al., SPIE Adv. Resist Technol. Process 1466, 39 (1991), or by a combination of both mechanisms. The polymeric compositions are selected so that the resist compositions are soluble in aqueous alkaline developers when in the non-crosslinked state, and are essentially insoluble in the aqueous alkaline developers when crosslinked. Preferred polymers include hydroxyaromatic polymers which are the condensation reaction product of a substituted or unsubstituted phenol with an aldehyde. Preferred polymers also include polymers or copolymers derived from a substituted or unsubstituted hydroxystyrene, by which is meant that the polymers or copolymers have an aliphatic or partially aliphatic polymer backbone and have hydroxyaromatic groups pendent therefrom. More preferred polymers include novolak resins, and polymers which are the condensation reaction product of formaldehyde with phenol or an alkylphenol, and polyhydroxystyrene.

In an alternate embodiment, the polymer may be a copolymer derived from a substituted or unsubstituted hydroxystyrene and an olefinically substituted cyclic alcohol. In an alternate preferred embodiment, the polymer may be poly(hydroxystyrene-co-vinyl cyclohexanol) which is described in US-A-5128232.

The poly(hydroxystyrene-co-vinyl cyclohexanol) has the form 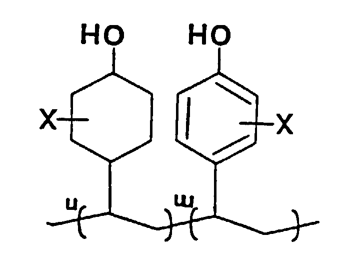 where X is, independently, a hydrogen or an alkyl group having 1 to 8 carbons, and m is in the range of about 0.8 to 1, and n is in the range of about 0 to 0.2.

The radiation sensitive acid generators which are useful in the present invention include metallic and non-metallic onium salts of the type described in US-A 4 102 687, aryl sulfonates, or N-hydroxyimides of the type described in US-A 4 371 605. Preferred radiation sensitive acid generators include the acid progenitors described in copending EP Patent Application entitled "Chemically Amplified Photoresists Comprising Non-Metallic Photosensitive Acid Generators". Examples of preferred radiation sensitive acid generators disclosed in the cited application include N-(trifluoromethylsulfonyloxy)-bicyclo[2.2.1]hept-5-ene-2,3 -dicarboximide (MDT), N-(trifluoromethylsulfonyloxy)-nitronaphthalimides, N-(trifluoromethylsulfonyloxy)-4-halonaphthalimides, N,N'-bis(camphorsulfonyloxy)-3,4,9,10-perylenetetracarboxdiimide, N-(trifluoromethylsulfonyloxy)-7-oxabicyclo-[2.2.1]hept-5-ene-2,3-dicarboximide, N-(trifluoromethylsulfonyloxy) -succinimide, N,N'-bis- (trifluoromethylsulfonyloxy)-(3-methyl-4,5-imidocyclohex-3-enyl)-succinimide, N-(trifluoromethylsulfonyloxy)-diphenylmaleimide, di-[N-(trifluoromethylsulfonyloxy)-phthalimidyl]ether, bistrifluoromethyl-bis-N,N'-(trifluoromethylsulfonyloxy)-ph thalimidylmethane, N-(camphorsulfonyloxy)-naphthalimide, N-(camphorsulfonyloxy)-nitronaphthalimides, and the corresponding tosyl-, brosyl-, fluoro- and polyfluorobenzenesulfonyloxy-, nitrobenzenesulfonyloxy-, and halobenzenesulfonyloxy- analogs thereof.

The crosslinking agents of the invention can be formulated into negative working chemically amplified resist compositions that produce lithographic features which have a relationship between image size and post-expose bake temperature of less than about a 10 nm change in linewidth per degree C. The crosslinking agents contain acid labile groups that are capable of forming carbonium ions in the presence of a strong acid, which carbonium ion comprising compounds are capable of entering into electrophilic aromatic substitution reactions. The crosslinking agents are also characterized as not acting to plasticize or soften the host polymeric binder upon mixing with the binder.

Preferred crosslinking compounds of the invention do not reduce the Tg of the polymeric binder into which the crosslinking agents are mixed. In alternative embodiments, the preferred crosslinking compounds of the invention will be selected to have melting points (mp) which are not less than the Tg of the polymeric binder into which the crosslinking agents are mixed. In additional, alternative, embodiments, those preferred crosslinking compounds of the invention which are polymeric or resinous in character will be selected to have Tg(s) which are not less than the Tg of the polymeric binder into which the crosslinking agents are mixed. In more preferred alternative embodiments, the melting points of the crosslinking agents exceed the Tg of the polymeric binder into which the crosslinking agents are mixed by about 10°C.

Examples of crosslinking agents include, without limitation, substituted glycolurils Examples of preferred crosslinking agents include, without limitation, tetrahydroxymethyl substituted glycolurils and tetraalkoxymethyl substituted glycolurils such as tetramethoxymethyl glycoluril (TMMGU, mp 119°C). It has been surprisingly found that TMMGU is very useful in the present invention and will provide significant improvements in linewidth control during fluctuations in PEB temperature.

These crosslinking compounds will take the form 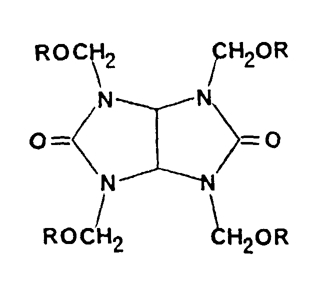 where R is, independently, H or CH3.

Rheometric measurements show that the glass transition temperature of the polymer film is not lowered when the crosslinkers of this invention are added. Therefore, it is believed that a higher Tg restricts the diffusion of the acid into unexposed regions during the PEB and thereby prevents a significant change in image size during typical variations in process conditions.

The polymeric compositions of the present invention may be dissolved in various solvents to provide a composition which is useful for forming thin films. Solvents may be esters, ethers, ketones, alcohols or other resist solvents known in the art. Particular examples of solvents include, without limitation, _-butyrolactone, ethyl lactate, acetate and propionate esters, 1-methoxy-2-propanol, tetrahydrofurfural alcohol, or combinations thereof. The preferred solvents are acetate and propionate esters and ethyl lactate.

Typical photoresist compositions will have up to about 50% solids. The proportion of crosslinking agent to binder may be in the range from about 50:50 to about 1:99. The proportion of acid generator to binder and crosslinking agent in combination may be in the range from about 0.5:99.5 to about 20:80.

In yet another alternative embodiment, traces of a surfactant may also be added to the resist compositions.

In yet another alternative embodiment, a dye may also be added to the resist compositions. The dye may be useful for modifying the optical properties of the resist, or may be useful as an energy transfer means. Dyes may include, without limitation, anthracenemethanol, phenoxymethylanthracene, 9,10-diphenylanthracene, substituted phenanthracenes and substituted biphenyls.

Typical process conditions which apply to all the examples listed below are the following: 125 mm silicon wafers were primed with hexamethyldisilazane (HMDS) before resist application. The wafers were spin coated with the resist solution and then baked for 1 minute at about 95°C to form approximately 1 µm thick films. After exposure, the wafers received a post-expose bake at 95°C for 1 minute and were spray or immersion developed for 1 minute in 0.14 N aqueous TMAH.

Table 1 summarizes the theoretical most preferred composition, based on analysis of the experimental data from the respective examples, for each example listed below. Values listed are % of total solids.

**Table 1**

| **Example** | **Novolak** | **PHS resin** | **TMMGU** | **MDT** | **9-anthracenemethanol** |
|---|---|---|---|---|---|
| 1,2,3 | 0 | 83.3 | 8.2 | 10.5 | 0 |
| 4 | 81 | 0 | 5 | 9 | 5 |

### Example 1

A resist composition comprising polyhydroxystyrene resin as a binder, N-trifluoromethylsulfonyloxy bicyclo[2.2.1]hept-5-ene-2,3-dicarboximide (MDT), and tetramethoxymethyl glycoluril (TMMGU) was imaged by exposure to Deep UV radiation with a Canon FP4500 KrF laser excimer stepper to produce half micron images with a change in linewidth of 5-10 nm per degree C change in PEB.

Specifically, polyhydroxystyrene was dissolved in propylene glycol monomethyl ether acetate (PMA) at a concentration of about 18% by weight, to which was added MDT at a concentration of about 12% by weight of polymer and TMMGU at a concentration of about 10% by weight of polymer. After the film was coated as described above, the wafer was exposed through a mask to about 10 mJ/cm² of 248 nm radiation. Following a PEB and TMAH development, 0.35 µm images were obtained showing 90° profiles.

The optimum proportion of each component was determined by exposing wafers with a Hg/Xe lamp through a mask containing a gradient of transmission steps. In this way, contrast and the dose to print could be calculated for each formulation. The range for the crosslinker is 1% to 50% by weight of the polymer while the preferred range is from 8 to 15%. The usable range of acid generator, in this case MDT, is from 0.5% to 20% by weight of polymer while the preferred range is 4 to 12%.

### Example 2

The bias associated with printing isolated features and a repetitive pattern of line/space features with the same mask is important when attempting to satisfy linewidth targets with tight tolerances as described earlier. An experimental matrix was designed to optimize the formulation listed for Example 1 in Table 1 so that the bias between isolated features and line/space patterns could be minimized or ideally reduced to zero. Table 2 summarizes the results obtained by process conditions used in Example 1. The responses measured were bias and linearity. A linearity to 0.35 µm means that 0.35 µm features can be printed to size at the same dose as larger features are printed to size.

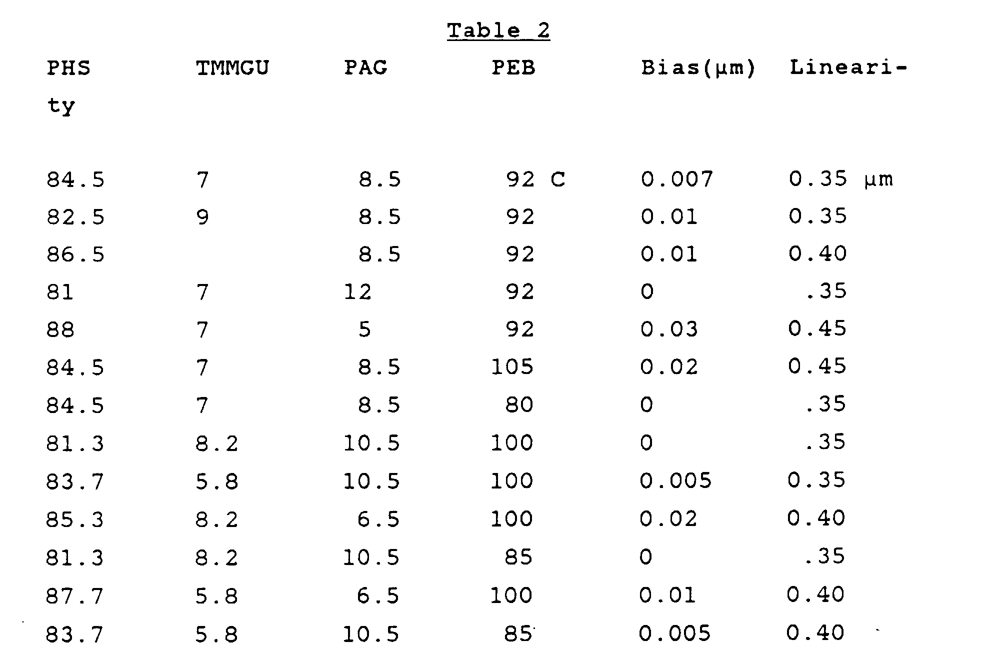

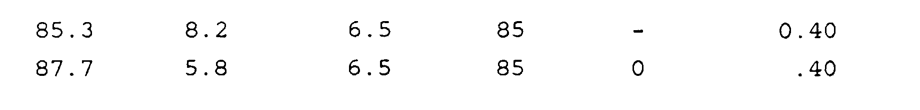

### Example 3

The formulation listed for Example 3 in Table 1 was used for this experiment. Wafers were coated and baked as described previously to provide approximately 1 µm thick films. Wafers were exposed at doses ranging from 100 to 200 Mj/cm² on an X-ray synchrotron and received a PEB of 100°C for 60 seconds. After the usual develop method, excellent 0.25 µm line/space patterns were resolved. The evaluation of linewidth vs. PEB temperature was repeated with X-ray exposures. At a 180 Mj/cm² dose and a 0.30 µm target dimension, linewidth changed from 0.275 µm at 90°C PEB to 0.35 µm at a 105°C PEB. This represents a change of about 5 nm per degree C. Wafers were processed in the same manner for electron beam exposures on a 50 kV exposure system and we obtained well resolved 0.25 µm line/space patterns.

### Example 4

The formulation listed as Example 4 in Table 1 was used for this series of experiments. A dye additive, 9-anthracene methanol, is added in order to provide absorbance at the 365 nm exposure wavelength and also transfers energy to the acid generator (which does not absorb at 365 nm). The goal was to develop this system for high resolution I-line lithography which would be compatible with the industry standard 0.263 N TMAH developer. The formulation was optimized according to four parameters listed in Table 2. Post-apply bake temperature was fixed at 90°C for 60 seconds and the developer was kept at 0.263 N TMAH. The formulations listed in Table 2 were imaged by exposure to 365 nm radiation with a Canon 2000I (0.52NA) I-line stepper to produce images as small as 0.35 µm. The responses of depth of focus (DOF) and dose latitude in Table 3 apply to 0.7 µm images and are a measure of the process window. Larger values for DOF and dose latitude indicate a more robust process that would be easier to implement in manufacturing.

**Table 3**

| **Novolak** | **TMMGU** | **PAG** | **PEB** | **DOF** | **Dose lat.** |
|---|---|---|---|---|---|
| 84 % | 6 % | 10 % | 115 deg | 2.8 µm | 39% |
| 82 | 8 | 10 | 115 | 3 | 38 |
| 86 | 4 | 10 | 115 | 2.4 | 40 |
| 82 | 6 | 12 | 115 | 3 | 40 |
| 86 | 6 | 8 | 115 | 2.4 | 32 |
| 84 | 6 | 10 | 120 | 3 | 40 |
| 81.7 | .2 | 11.2 | 117 | 3 | 35 |
| 84.6 | 4.8 | 11.2 | 117 | 3 | 40 |
| 84 | 7.2 | 8.8 | 117 | 2.1 | 26 |
| 81.6 | 7.2 | 11.2 | 113 | 3 | 35 |
| 86.4 | .8 | .8 | 117 | 3 | 26 |
| 84.6 | 4.8 | 11.2 | 113 | 2.1 | 32 |
| 84 | 7.2 | 8.8 | 113 | 2.1 | 24 |
| 86.4 | .8 | .8 | 113 | 1.8 | 41 |

PEB temperatures from 114°C to 122°C were used and linewidth measurements taken for 0.4 and 0.5 µm feature sizes indicate a change in image size of 5.5 nm per degree C which is consistent with results from Examples 1 and 2.

### Example 5

Thermo-mechanical properties of films cast from the negative resist composition described in Example 4 were determined in the following way. G-2 novolak resin was blended with approximately 5% by weight of either Cymel 303 (liquid at room temperature) or TMMGU (melting point 119 C). Spin cast films of these compositions were prepared in accordance with Example 4. Thermo-mechanical properties of these films were compared with G-2 novolak alone and to a commercially available negative DUV resist comprising a Cymel 303 crosslinking agent via parallelplate viscometry. In this technique, a solid material is interposed between a stationary and rotating pair of plates. As the temperature of the assembly is raised, induced torque in the stationary plate is monitored. This torque is then related to the glass transition temperature, Tg, of the composite film. Data from this analysis has an accuracy of about ± 5°, and is summarized in table 4 below:

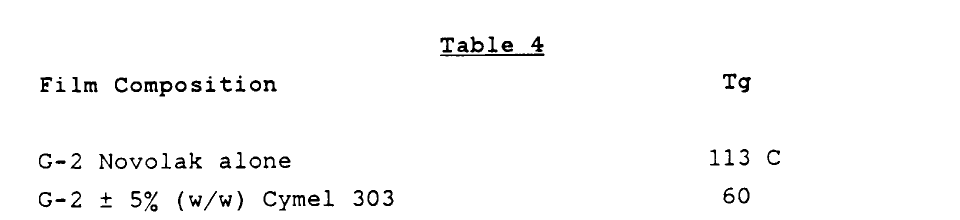

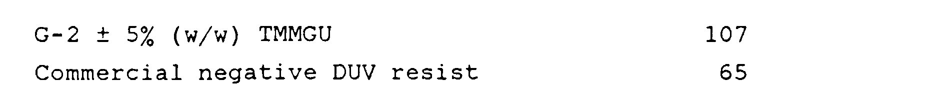

This example illustrates the effect of crosslinker type on the thermo-mechanical properties of the film as measured by Tg. It is evident from table 4 that melamine type crosslinkers (Cymel 303 type) dramatically reduce the Tg of the film while TMMGU has little effect. It will be apparent to those skilled in the art that dramatic reduction in Tg is undesirable due to the enhancement in photoacid diffusion brought about by this reduction, leading to greater dependence of linewidth on post-exposure bake temperature. The unique thermal stability associated with the TMMGU may be the primary factor which accounts for its superior post-exposure bake stability as indicated in Example 1.

### Example 6

The photoresist composition of Example 1 was processed by a dry development method as follows. Following exposure and post exposure bake as in the previous examples, the resist film was silylated by using hexamethylcyclo-trisilazane (HMCTS) in a Monarch silylation tool. The process included a pre-silylation bake at about 110°C. for about 10 sec, followed by silylation for about 2 minutes at about 110°C and at a pressure of about 100 to 150 torr, then followed by a final post-silylation bake at about 110°C for about 10 sec. The dry developing etch process was carried out on a AME-5000 etching system in two steps. The silylated resist was first etched for 10 seconds using a high pressure low magnetic field O2 RIE process, then followed by a low pressure high magnetic O2 RIE step until completion.

### Example 7

In the composition similar to that of example 1, a condensation polymer derived from formaldehyde and bisphenol-A was substituted for the poly(hydroxystyrene) polymeric binder described in example 1. The formaldehyde bisphenol-A polymer is commercially available under the tradename RDX from Hi Tek Polymers Company, Louisville, Ky. The resulting negative resist composition was functionally similar to the resist of example 1 with the exception that 0.5 µm structures were resolved.

## Claims

1. A negative tone microlithographic resist composition comprising in admixture:
a binder comprising a hydroxyaromatic polymer which is soluble in aqueous alkaline developer solution and which becomes crosslinked by an electrophilic aromatic substitution reaction with a crosslinking agent to become insoluble in the aqueous alkaline developer solution,
a crosslinking agent comprising a substituted glycouril which forms a carbonium ion upon reaction with a strong acid catalyst, which crosslinking agent does not plasticize the polymeric binder when admixed therewith, and
an acid generating compound which forms a strong acid upon exposure to radiation.

2. The composition of claim 1 wherein said acid generating compound is selected from the group consisting of :
N-(trifluoromethylsylfonyloxy)-bicyclo [2.2.1] hept-5-ene-2,3-dicarboximide (MDT), N,N'-bis(camphorsulfonyloxy)-3,4,9,10-perylenetetracarboxdiimide, N,N'-bis-(trifluoromethylsulfonyloxy)-(3-methyl-4,5-imidocyclohex-3-enyl)-succinimide, and N-(trifluoromethylsulfonyloxy)-diphenylmaleimide.

3. The composition of claim 1 or 2 wherein the hydroxyaromatic polymer is the condensation reaction product of a substituted or unsubstituted phenol with an aldehyde.

4. The composition of claim 3 wherein the hydroxyaromatic polymer is the condensation reaction product of formaldehyde with phenol or an alkylphenol.

5. The composition of claim 1 wherein the hydroxyaromatic polymer is the polymeric reaction product of a substituted or unsubstituted hydroxystyrene.

6. The composition of claim 5 wherein the hydroxyaromatic polymer is polyhydroxystyrene.

7. The composition of claim 5 wherein the hydroxyaromatic polymer is a copolymeric reaction product of a substituted or unsubstituted hydroxystyrene and an olefinically substituted cyclic alcohol.

8. The composition of claim 1 wherein the crosslinking agent does not reduce the glass transition temperature of the polymeric binder when admixed therewith.

9. The composition of claim 1 wherein the melting point of the crosslinking agent is not less than the glass transition temperature of the hydroxyaromatic polymer.

10. The composition of claim 9 wherein the melting point of the crosslinking agent is at least 10°C greater than the glass transition temperature of the hydroxyaromatic polymer.

11. The composition of claim 1 wherein the crosslinking agent is a 1,3,5,7-tetraalkoxymethylglycouril or 1,3,5,7-tetrahydroxymethylglycouril.

12. The composition of claim 11 wherein the crosslinking agent is 1,3,5,7-tetramethoxymethylglycouril.

13. The composition of claim 1 additionally comprising a dye.

14. The composition of claim 13 wherein the dye absorbs energy from actinic radiation having one or more wavelengths in the range from about 180 nm to about 400 nm and said dye transfers absorbed energy to the acid generating compound to form a strong acid.

15. The composition of claim 13 wherein the dye is selected from the group consisting of anthracenemethanol phenoxymethylanthracene, 9,10-diphenylanthracene, substituted phenanthracenes and substituted biphenyls.

16. The composition of claim 1 additionally comprising a solvent.

17. A method for forming a microlithographic relief image comprising the steps of:
applying, to a microlithographic substrate, a radiation sensitive thin film of the resist composition according to any above claim,
patternwise exposing the radiation sensitive thin film to radiation to form a latent image,
heating the thin film to cause crosslinking of the hydroxyaromatic polymer in the exposed areas of the latent image, and
developing the latent image in aqueous alkaline solution to form a relief image in the thin film.

18. The method of claim 17 wherein the temperature to which the thin film is heated to cause crosslinking of the hydroxyaromatic polymer in the exposed areas does not exceed the melting point of the crosslinking agent.

19. The method of claim 17 wherein the radiation is an electron beam, ultraviolet radiation, or x-ray radiation.

## Patentansprüche

1. Mikrolithographische Negativton-Resistzusammensetzung, die in Zumischung beinhaltet:
ein Bindemittel, das ein hydroxyaromatisches Polymer beinhaltet, das in einer wäßrigen alkalischen Entwicklerlösung löslich ist und das durch eine elektrophile aromatische Substitutionsreaktion mit einem Vernetzungsmittel vernetzt wird, um in der wäßrigen alkalischen Entwicklerlösung unlöslich zu werden,
ein Vernetzungsmittel, das ein substituiertes Glycouril beinhaltet, das bei Reaktion mit einem starken Säurekatalysator ein Carbonium-Ion bildet, wobei das Vernetzungsmittel das polymere Bindemittel bei Zumischung zu demselben nicht plastifiziert, und
eine Verbindung, die eine Säure erzeugt, die bei Einwirken von Strahlung eine starke Säure bildet.

2. Zusammensetzung nach Anspruch 1, wobei die eine Säure erzeugende Verbindung aus der Gruppe ausgewählt ist, die besteht aus:
N-(trifluormethylsulfonyloxy)bicyclo[2.2.1]hept-5-en-2,3-dicarboximid (MDT), N, N'-bis(kampfersulfonyloxy)-3,4,9,10-perylentetracarboxdiimid, N, N'-bis- (trifluormethylsulfonyloxy)-(3-methyl-4,5-imidocyclohex-3-enyl)-succinimid und N-(trifluormethylsulfonyloxy)-diphenylmaleimid.

3. Zusammensetzung nach Anspruch 1 oder 2, wobei das hydroxyaromatische Polymer das Produkt der Kondensationsreaktion eines substituierten oder nicht substituierten Phenols mit einem Aldehyd ist.

4. Zusammensetzung nach Anspruch 3, wobei das hydroxyaromatische Polymer das Produkt der Kondensationsreaktion von Formaldehyd mit Phenol oder einem Alkylphenol ist.

5. Zusammensetzung nach Anspruch 1, wobei das hydroxyaromatische Polymer das polymere Reaktionsprodukt eines substituierten oder nicht substituierten Hydroxystyrols ist.

6. Zusammensetzung nach Anspruch 5, wobei das hydroxyaromatische Polymer Polyhydroxystyrol ist.

7. Zusammensetzung nach Anspruch 5, wobei das hydroxyaromatische Polymer ein copolymeres Reaktionsprodukt eines substituierten oder nicht substituierten Hydroxystyrols und eines olefin-substituierten cyclischen Alkohols ist.

8. Zusammensetzung nach Anspruch 1, wobei das Vernetzungsmittel die Glasübergangstemperatur des polymeren Bindemittels beim Zumischen zu demselben nicht reduziert.

9. Zusammensetzung nach Anspruch 1, wobei der Schmelzpunkt des Vernetzungsmittels nicht niedriger als die Glasübergangstemperatur des hydroxyaromatischen Polymers ist.

10. Zusammensetzung nach Anspruch 9, wobei der Schmelzpunkt des Vernetzungsmittels um wenigstens 10 °C höher als die Glasübergangstemperatur des hydroxyaromatischen Polymers ist.

11. Zusammensetzung nach Anspruch 1, wobei das Vernetzungsmittel ein 1,3,5,7-Tetraalkoxymethylglycouril oder ein 1,3,5,7-Tetrahydroxymethylglycouril ist.

12. Zusammensetzung nach Anspruch 11, wobei das Vernetzungsmittel 1,3,5,7-Tetramethoxymethylglycouril ist.

13. Zusammensetzung nach Anspruch 1, die zusätzlich einen Farbstoff beinhaltet.

14. Zusammensetzung nach Anspruch 13, wobei der Farbstoff Energie von aktinischer Strahlung mit einer oder mehreren Wellenlängen im Bereich von etwa 180 nm bis etwa 400 nm absorbiert und der Farbstoff absorbierte Energie auf die eine Säure erzeugende Verbindung überträgt, um eine starke Säure zu bilden.

15. Zusammensetzung nach Anspruch 13, wobei der Farbstoff aus der Gruppe ausgewählt ist, die aus Anthracenmethanol, Phenoxymethylanthracen, 9,10-Diphenylanthracen, substituierten Phenanthracenen und substituierten Biphenylen besteht.

16. Zusammensetzung nach Anspruch 1, die zusätzlich ein Lösungsmittel beinhaltet.

17. Verfahren zur Erzeugung eines mikrolithographischen Reliefbildes, das die Schritte umfaßt:
Anbringen eines strahlungsempfindlichen Dünnfilms aus der Resistzusammensetzung gemäß irgendeinem der obigen Ansprüche auf einem mikrolithographischen Substrat,
strukturweises Belichten des strahlungsempfindlichen Dünnfilms mit Strahlung, um ein latentes Bild zu erzeugen,
Erwärmen des Dünnfilms, um ein Vernetzen des hydroxyaromatischen Polymers in den belichteten Gebieten des latenten Bildes zu bewirken, und
Entwickeln des latenten Bildes in wäßriger alkalischer Lösung, um ein Reliefbild in dem Dünnfilm zu erzeugen.

18. Verfahren nach Anspruch 17, wobei die Temperatur, auf die der Dünnfilm erwärmt wird, um ein Vernetzen des hydroxyaromatischen Polymers in den belichteten Gebieten zu bewirken, den Schmelzpunkt des Vernetzungsmittels nicht übersteigt.

19. Verfahren nach Anspruch 17, wobei die Strahlung aus einem Elektronenstrahl, ultravioletter Strahlung oder Röntgenstrahlung besteht.

## Revendications

1. Composition de photoréserve microlithographique de type négatif comprenant en mélange :
un liant comportant un polymère hydroxyaromatique qui est soluble dans une solution développatrice alcaline aqueuse et qui devient réticulé par une réaction de substitution aromatique électrophile avec un agent de réticulation pour devenir insoluble dans la solution développatrice alcaline aqueuse,
un agent de réticulation contenant un glycouril substitué qui forme un ion carbonium lors de la réaction avec un catalyseur d'acide fort, lequel agent de réticulation ne plastifie pas le liant polymérique lorsqu'il lui est mélangé, et
un composé générateur d'acide qui forme un acide fort lorsqu'il est exposé à un rayonnement.

2. Composition selon la revendication 1, dans laquelle ledit composé générateur d'acide est choisi dans le groupe constitué de :
N-(trifluorométhylsulfonyloxy)-bicyclo [2,2,1] hept-5-ène-2,3-dicarboximide (MDT), N,N'-bis(camphorsulfonyloxy)-3,4,9,10-pérylènetétracarboxydiimide, N,N'-bis (trifluorométhylsulfonyloxy) (3-méthyl-4,5-imido-cyclohex-3-ényl)succinimide, et de N-(trifluorométhylsulfonyloxy)diphénylmaléimide.

3. Composition selon la revendication 1 ou 2, dans laquelle le polymère hydroxyaromatique est le produit de la réaction de condensation d'un phénol substitué ou non substitué avec un aldéhyde.

4. Composition selon la revendication 3, dans laquelle le polymère hydroxyaromatique est le produit de la réaction de condensation du formaldéhyde avec le phénol ou un alkylphénol.

5. Composition selon la revendication 1, dans laquelle le polymère hydroxyaromatique est le produit de la réaction de polymérisation d'un hydroxystyrène substitué ou non substitué.

6. Composition selon la revendication 5, dans laquelle le polymère hydroxyaromatique est le polyhydroxystyrène.

7. Composition selon la revendication 5, dans laquelle le polymère hydroxyaromatique est un produit de la réaction de copolymérisation d'un hydroxystyrène substitué ou non substitué avec un alcool cyclique substitué de manière oléfinique.

8. Composition selon la revendication 1, dans laquelle l'agent de réticulation ne réduit pas la température de transition vitreuse du liant polymérique lorsqu'il lui est mélangé.

9. Composition selon la revendication 1, dans laquelle le point de fusion de l'agent de réticulation n'est pas inférieur à la température de transition vitreuse du polymère hydroxyaromatique.

10. Composition selon la revendication 9, dans laquelle le point de fusion de l'agent de réticulation est supérieur d'au moins 10°C à la température de transition vitreuse du polymère hydroxyaromatique.

11. Composition selon la revendication 1, dans laquelle l'agent de réticulation est un 1,3,5,7-tétraalcoxyméthylglycouril ou le 1,3,5,7-tétrahydroxyméthylglycouril.

12. Composition selon la revendication 11, dans laquelle l'agent de réticulation est le 1,3,5,7-tétraméthoxyméthylglycouril.

13. Composition selon la revendication 1, comprenant en outre un colorant.

14. Composition selon la revendication 13, dans laquelle le colorant absorbe l'énergie provenant du rayonnement actinique ayant une ou plusieurs longueurs d'onde dans l'intervalle d'environ 180 nm à environ 400 nm et dans laquelle ledit colorant transfère l'énergie absorbée au composé générateur d'acide pour former un acide fort.

15. Composition selon la revendication 13, dans laquelle le colorant est choisi dans le groupe constitué de l'anthracèneméthanol, le phénoxyméthylanthracène, le 9,10-diphénylanthracène, des phénanthracènes substitués et des biphényles substitués.

16. Composition selon la revendication 1, comprenant en outre un solvant.

17. Procédé pour former une image en relief microlithographique comprenant les étapes consistant à :
appliquer, à un substrat microlithographique, un film mince sensible au rayonnement de la composition de réserve selon l'une quelconque des revendications précédentes,
exposer conformément au motif le film mince sensible au rayonnement à un rayonnement en vue de former une image latente,
chauffer le film mince pour provoquer la réticulation du polymère hydroxyaromatique dans les zones exposées de l'image latente, et
développer l'image latente dans une solution alcaline aqueuse pour former une image en relief dans le film mince.

18. Procédé selon la revendication 17, dans lequel la température à laquelle le film mince est chauffé pour provoquer la réticulation du polymère hydroxyaromatique dans les zones exposées ne dépasse pas le point de fusion de l'agent de réticulation.

19. Procédé selon la revendication 17, dans lequel le rayonnement est un faisceau électronique, un rayonnement ultraviolet ou un rayonnement de rayons X.
